# EUROPEAN PATENT SPECIFICATION

(11) **EP 0 548 870 B1**
(45) Date of publication and mention of the grant of the patent: **05.11.1997**
(21) Application number: 92121684.2
(22) Date of filing: 21.12.1992
(51) Int. Cl.: G03C 7/12, G03F 7/027

(54) **Color filter**
Farbfilter
Filtre couleur

(30) Priority: 24.12.1991 JP 341063/91
(43) Date of publication of application: 30.06.1993
(73) Proprietor: OJI KAKO CO., LTD., Nihonbashi Chuo-ku Tokyo (JP)
(72) Inventor: Itoh, Hiroshi, c/o Oji Kako Co., Ltd., Utsunomiya-shi, Tochigi (JP); Nakazato, Shuichi, c/o Oji Kako Co., Ltd., Utsunomiya-shi, Tochigi (JP); Matsumura, Takahisa, c/o Oji Kako Co., Ltd., Utsunomiya-shi, Tochigi (JP); Sato, Kyoichi, c/o Oji Kako Co., Ltd., Utsunomiya-shi, Tochigi (JP)
(74) Representative: Kador & Partner

(56) References cited:
- US-A- 4 169 737
- US-A- 5 055 379
- US-A- 5 096 801

## Description

### BACKGROUND OF THE INVENTION

### (1) Field of the Invention

The present invention relates to a color filter formed by using a photosensitive resin composition comprising an aqueous resin emulsion containing an internally added pigment and a photocrosslinking agent and particularly to a color filter for use in a solid image pickup device, a color liquid crystal display device and other devices.

### (2) Description of the Prior Art

Color filters used in a color solid image pickup device (for example, image pickup IC's such as CCD, CID and BBD) having a large demand for a camera for a VTR, a color liquid crystal display device, etc., comprises a solid image pickup device or a transparent substrate and, provided thereon, a fine region colored in two or more hues. In general, in order to give a color in two or more different hues to a fine region, use is made of a photosensitive resin composition capable of forming a transparent colored image.

The formation of two or three or more transparent colored images from a photosensitive resin has hitherto been conducted, for example, by coating a substrate with a photosensitive resin comprising a naturally occurring or synthetic polymer substance, such as gelatin, casein, glue or partially saponified polyvinyl acetate, and, added thereto, a photosensitive material, such as dichromate or a diazo compound, to provide a mordant layer. The mordant layer is exposed to an ultraviolet radiation through a mask having a predetermined pattern, and development is conducted to dye the mordant layer with a desired dye, thereby forming a colored image having a first hue. Then, a transparent resin film for protection against dyeing, which comprises a hydrophobic resin, is formed on the first transparent colored image for the purpose of preventing the dye from migrating. Thereafter, a second transparent colored image is formed in the same manner as that used in the formation of the first transparent colored image. The repetition of the above-described procedure provides a transparent colored image colored in two or three or more hues on the substrate.

According to the above-described method, however, since it is necessary to form a resin film for protection against dyeing for each step of dyeing in each color, the production process is very complicated. Further, the resin film for protection against dyeing causes an uneven portion to be formed, which gives rise to problems such as likelihood of an occurrence of a difference in the film thickness of the colored image. Further, in some color filters which are heated in the production process, since the heat resistance, light fastness and other properties of the dye per se are generally low, there occur problems such as fading.

Besides the above-described method, the formation of a color filter by printing is one of the simplest processes for producing a color filter. This method, however, has positional accuracy and dimensional accuracy limitations, so that no color filter having a high accuracy and a high fineness can be produced.

A method wherein a color filter is formed from a photosensitive resin previously colored through the use of a pigment is considered useful for overcoming the above-described problems. This method is shorter in the production process and simpler as compared with the dyeing method because of the formation of a resin film for protection against dyeing for each step of dying in each color. Since this method has advantages including the heat resistance of the pigment being superior to that of the dye, many proposals in connection with this method have been made in the art. For example, Japanese Unexamined Patent Publication (Kokai) Nos. 60-237403, 61-254906 and 2-153353 disclose the dispersion of a pigment in a polyamide resin, a polyimide resin or an acrylic resin. Since, however, it is difficult to stably disperse the pigment in a high concentration, pigment particles settle or re-aggregate with the elapse of time. Further, the addition of a dispersant for the purpose of improving the dispersibility is liable to give rise to problems such as a poor adhesion between the substrate and the colored image and a deterioration in water resistance, solvent resistance and chemical resistance of the colored image due to the influence of the dispersant.

Further, as disclosed in Japanese Unexamined Patent Publication (Kokai) Nos. 60-129738, 60-129739 and 60-129707, studies have been conducted on a method wherein a colored image is formed by dispersing a pigment in a partially saponified polyvinyl acetate which enables development to be conducted with water. In this case as well, a problem of the dispersion of the pigment occurs, which leads to a drawback that the pigment particles settle, a drawback that the pigment particles re-aggregate, a drawback that the pigment per se has an inherent property that satisfactory dispersion thereof in partially saponified polyvinyl acetate is difficult, a drawback that a portion where no pigment is present occurs on the coating and other drawbacks, so that no homogeneous colored image can be formed. Further, even though a dispersant is added for the purpose of improving the dispersibility, a problem such as a deterioration in the adhesion between the substrate and the colored image is liable to occur due to the influence of the dispersant. Further, some color filters are exposed to a high temperature of 200 to 300°C in vacuum deposition in the formation of an overcoat layer, etc., which causes the partially saponified polyvinyl acetate as a binder resin to be unfavorably colored.

The present invention solves the above-described drawbacks of the prior art, and objects of the present invention are:
1) to provide a color filter which can be produced by a process simplified by making it unnecessary to form a transparent resin film for protection against dyeing for each step of dyeing in each color;
2) to provide a color filter having a homogeneous transparent colored image by virtue of a stable dispersion of a pigment in a high concentration; and
3) to provide a color filter having a transparent colored image excellent in heat resistance and light fastness.

As described in Japanese Unexamined Patent Publication (Kokai) Nos. 58-7646, 59-33302, 62-288632 and 2-187402, it is known in the art that a colored, aqueous resin emulsion and a colored fine particle can be prepared by dispersing a pigment in a compound having an ethylenically unsaturated group and subjecting the dispersion to a suspension heat polymerization in the presence of a protective colloid agent in an aqueous medium. However, all of these are used for coating or toner applications for mere coloration or masking.

The transparency of a dried coating of a colored, aqueous resin emulsion produced by the above-described method has been considered low due to incomplete dispersion of the pigment in a compound having an ethylenically unsaturated group. For this reason, the above-described colored, aqueous resin emulsion containing an internally added pigment has been regarded unsuitable as a material for a previously colored photosensitive resin for color filter applications where a high transparency is required of the coating.

The present inventors, however, have found that a dried coating of the above-described colored, aqueous resin emulsion containing an internally added pigment has a high transparency contrary to expectations and can be satisfactorily used as a material for color filter applications. The reason for this is believed to reside in that even in the case of a pigment incompletely dispersed in a compound having an ethylenically unsaturated group, when such a pigment is emulsified by means of a protective colloid agent or other agent capable of emulsifying a compound having an ethylenically unsaturated group, as the compound having an ethylenically unsaturated group is emulsified, the pigment as well is completely dispersed in the compound having an ethylenically unsaturated group, which contributes to an increase in the transparency. Another possible reason is that the ethylenically unsaturated compound containing an incompletely dispersed pigment, as such, becomes a fine particle form having a diameter reduced to such an extent that a high transparency is attained.

### SUMMARY OF THE INVENTION

Accordingly, the present inventors have found that the reduction of the particle diameter of the above-described aqueous resin emulsion containing an internally added pigment to not more than the wavelength of incident light enables the transparency of the resultant dried coating to be further enhanced, and that the above-described objects can be attained by forming a color filter through the use of a photosensitive resin composition comprising a combination of an aqueous resin emulsion containing an internally added pigment with a photocrosslinking agent, which has led to the completion of the present invention.

According to the present invention, there is provided a color filter comprising a substrate and, provided thereon, a pattern having a plurality of colors produced by conducting photocrosslinking of a photosensitive resin composition comprising: an aqueous resin emulsion containing an internally added pigment, said aqueous resin emulsion being produced by subjecting a compound having an ethylenically unsaturated group to emulsion polymerization or suspension polymerization in water in the presence of a pigment; and a photocrosslinking agent.

### BRIEF DESCRIPTION OF THE DRAWINGS

Fig. 1 is a cross-sectional view showing the first step in an example of a process for producing the color filter according to the present invention;
Fig. 2 is a cross-sectional view showing the second step in the above example of a process for producing the color filter according to the present invention;
Fig. 3 is a cross-sectional view showing the third step in the above example of a process for producing the color filter according to the present invention; and
Fig. 4 is a cross-sectional view of the color filter of the present invention produced by the above example.

### DESCRIPTION OF THE PREFERRED EMBODIMENTS

In the photosensitive resin composition useful in the present invention, the dispersion of a pigment in a compound having an ethylenically unsaturated group followed by emulsion polymerization or suspension polymerization causes the pigment to be immobilized within an emulsion particle to prevent the pigment from aggregating or settling, thus enabling a high dispersion stability to be attained, so that it becomes possible to form a color filter having a homogeneous, transparent colored image.

Further, it has been found that since the pigment particle is completely embraced by a coating layer of a continuous polymer, the effect of preventing the occurrence of fading derived from light and preventing the electrification of the pigment can be expected from the polymer coating.

Further, it has been found that as described in a literature entitled "Emulsion Polymerization of Vinyl Acetate" in Applied Science Publishers, when use is made of a partially saponified polyvinyl acetate as a protective colloid for emulsion polymerization or suspension polymerization, since a compound having an ethylenically unsaturated group is chemically or physically grafted on an acetate residue of a saponification product of polyvinyl acetate to give rise to crosslinking to some extent, effects unexpected from the prior art can be attained such as an improvement in the heat resistance over the case where they are merely in a dissolved state and partially saponified polyvinyl acetate is liberated in water. Further, it has been found that as disclosed in Japanese Examined Patent Publication (Kokoku) No. 44-25794 and Japanese Unexamined Patent Publication (Kokai) No. 63-81101, when emulsion polymerization or suspension polymerization is conducted in the presence of a partially saponified polyvinyl acetate derivative having a reactive unsaturated group as a protective colloid, the grafting with the compound having an ethylenically unsaturated group is increased, that is, the heat resistance is increased. Further, since the partially saponified polyvinyl acetate derivative having a reactive unsaturated group, as such, has a function of emulsifying the compound having an ethylenically unsaturated group, a stable aqueous resin emulsion can be prepared without use of a significant amount of a surfactant or through the use of a relatively small amount of a surfactant, so that the adhesion, water resistance, solvent resistance, chemical resistance, etc. are good.

The use of a photosensitive resin composition having these excellent features enables a color filter having a high quality to be produced.

In the present invention, the pigment is incorporated in the compound having an ethylenically unsaturated group. Although the pigment used may be any of organic and inorganic pigments, it is preferred for the pigment to have excellent heat resistance, light fastness and solvent resistance. Examples of the organic pigment include azo, phthalocyanine, benzimidazolone, quinacridone, isoindolinone, pyranthrone, dibromoansanthrone, indanthrone, anthrapyrimidine, flavanthrone, perylene, perinone, quinophthalone, phthalone, thioindigo, indigo, dioxazine, anthraquinone, xanthene, methine and azomethine pigments and other polycondensed ring pigments including metal complex polycondensed ring pigments. Examples of the inorganic pigment include milori blue, iron oxide, cobalt violet, manganese violet, ultramarine blue, iron blue, cobalt blue, cerulean blue, viridian, emerald green and cobalt green. One or more pigments are properly selected therefrom.

The particle diameter of these organic and inorganic pigments is 0.7 µm or less, preferably 0.1 µm or less from the viewpoint of light transmission and homogeneity of coating surface and preferably sufficiently smaller than the wavelength of visible light.

The compound having an ethylenically unsaturated group is a compound having at least one ethylenically unsaturated group in its molecule, and examples thereof include alkyl acrylates (for example, methyl acrylate, ethyl acrylate, butyl acrylate and 2-ethylhexyl acrylate), alkyl methacrylates (for example, methyl methacrylate, ethyl methacrylate, butyl methacrylate and 2-ethylhexyl methacrylate), epoxy acrylates (including epoxy methacrylates), urethane acrylates (including urethane methacrylates), polyether acrylates (including polyether methacrylates), polyester acrylates (including polyester methacrylates), acrylic acid, methacrylic acid, glycidyl acrylate, glycidyl methacrylate, allyl acrylate, allyl methacrylate, itaconic acid, acrylamide, methacrylamide, dimethylaminoethyl acrylate, diethylaminoethyl methacrylate, hydroxyethyl acrylate, hydroxyethyl methacrylate, hydroxypropyl acrylate, hydroxypropyl methacrylate, N-methylolacrylamide, N-methylolmethacrylamide, acrylonitrile, styrene, α-methylstyrene, vinyl acetate, vinyltoluene, vinylpyridine, 2-hydroxy-3-phenoxypropyl acrylate, p-nonylphenoxyethyl acrylate, 1,6-hexanediol diacrylate, 1,6-hexanediol dimethacrylate, neopentyl glycol diacrylate, neopentyl glycol dimethacrylate, 2-hydroxy-1-acryloxy-3-methacryloxypropane, 3-butylene glycol dimethacrylate, 2,2-bis[4(acryloxy-polyethoxy)phenyl]propane, 2,2-bis[4(methacryloxy-polyethoxy)phenyl]propane, trimethylolpropane triacrylate, tetramethylolmethane triacrylate, tetramethylolmethane tetraacrylate, dipentaerythritol hexaacrylate, butadiene, isoprene, chloroprene, vinyl chloride, vinyl bromide, vinylidene chloride and vinylidene fluoride. These may be used alone or in combination of two or more thereof.

In the aqueous resin emulsion containing an internally added pigment and produced by polymerization of a combination of a compound having one ethylenically unsaturated group in its molecule, i.e., the so-called monofunctional compound with a pigment, since the crosslinking density within the emulsion particle is low, the film forming temperature is so low that there occur unfavorable phenomena such as fusing between particles during the formation of a coating by drying, a lowering in the redissolution in water, a high impossibility of complete removal of unexposed portion by the development and a high liability to remaining of color.

On the other hand, an aqueous resin emulsion containing an internally added pigment wherein the crosslinking density within emulsion particles is properly increased, that is, the film forming temperature is increased, through a combination of a compound having two or more ethylenically unsaturated group in its molecule, i.e., the so-called "polyfunctional compound", with a monofunctional compound or a combination of polyfunctional compounds has advantages such as freedom from the formation of a film derived from fusing between particles during drying, good redissolution in water and freedom from unsatisfactory development.

The pigment content in terms of the ratio of the weight (A) of the pigment to the weight (B) of the compound having an ethylenically unsaturated group, that is, A to B, is in the range of from 1 : 99 to 80 : 20, preferably in the range of from 10 : 90 to 40 : 60. The content is determined by taking spectral characteristics of the pigment and the color depth by the pigment into consideration.

The pigment-containing compound having an ethylenically unsaturated group is prepared by adding a pigment to a compound having an ethylenically unsaturated group, stirring them to form a mixture, sufficiently conducting dispersion by means of a homomixer, a ball mill, a roll mill, a sand grinder, etc., and removing particles having a large diameter by means of a filter. Use may be made of a dispersant when dispersion is conducted. It is preferred to conduct the dispersion in such a manner that the particle diameter of the pigment is smaller than the wavelength of visible light (0.4 to 0.7 µm). The particle diameter is particularly preferably 0.5 µm or less for a red pigment, 0.3 µm or less for a green pigment and 0.2 µm or less for a blue pigment.

Then, emulsion polymerization or suspension polymerization is conducted by making use of the above-described pigment-containing compound having an ethylenically unsaturated group according to a conventional method.

Examples of polymerization initiator useful in the polymerization include peroxides such as benzoyl peroxide, cumene hydroperoxide, succinic peroxide, lauroyl peroxide and hydrogen peroxide, azo compounds such as 2,2'-azobisisobutyronitrile, 2,2'-azobis(2,4-dimethylvaleronitrile) and 2,2'-azobis(2-amidinopropane) dibasic acid salt, persulfuric acid compounds such as ammonium persulfate and potassium persulfate, perchloric acid compounds, and redox catalysts such as a combination of the above-described persulfuric acid compound with a reducing sulfoxy compound and a combination of the perchloric acid compound with a reducing sulfoxy compound.

In this case, useful examples of the protective colloid include a partially saponified polyvinyl acetate having a degree of saponification of 70 to 99 % by mole and a degree of polymerization of 300 to 4000 and a partially saponified polyvinyl acetate derivative having a reactive unsaturated group as disclosed in Japanese Unexamined Patent Publication (Kokai) No. 63-81101.

Useful examples of other protective colloid agent include gelatin, casein, collagen, starch, starch derivatives, gum arabic, methyl cellulose, hydroxyethyl cellulose, carboxymethyl cellulose, polyacrylamide, polyacrylic acid and water-soluble nylon. Further examples of the protective colloid include water-soluble polymers having a reactive unsaturated group or a thiol group as disclosed in Japanese Examined Patent Publication No. 44-25794 and Japanese Unexamined Patent Publication (Kokai) No. 59-187005.

In some cases, the protective colloid, such as the above-described water-soluble polymer, may be used for the polymerization in combination with at least one surfactant selected from the group consisting of anionic surfactants, cationic surfactants, amphoteric surfactants and nonionic surfactants.

Alternatively, the polymerization may be conducted by using as an emulsification stabilizer at least one surfactant selected from the group consisting of anionic surfactants, cationic surfactants, amphoteric surfactants and nonionic surfactants without use of the protective colloid such as the above-described water-soluble polymer.

When use is made of these surfactants, it is preferred to use them in a relatively small amount because the use thereof in a large amount has an adverse effect on the water resistance of the transparent colored image and the adhesion between the transparent colored image and the substrate.

Then, a photosensitive resin composition is prepared by making use of the above-described aqueous resin emulsion containing an internally added pigment and produced by emulsion polymerization and suspension polymerization. Examples of possible construction of the photosensitive resin composition are as follows.
1. A mixture comprising: the above-described aqueous resin emulsion containing an internally added pigment wherein at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc., is polymerized as a protective colloid agent; and a diazo compound or a dichromate.
2. A mixture comprising: the above-described aqueous resin emulsion containing an internally added pigment wherein at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc., is polymerized as a protective colloid agent; at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc.; and a diazo compound or a dichromate.
3. A mixture comprising: the above-described aqueous resin emulsion containing an internally added pigment wherein at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc. is polymerized as a protective colloid agent; an emulsified dispersion produced by emulsifying at least one compound having an ethylenically unsaturated group selected from the group consisting of acrylic esters and methacrylic esters containing a photopolymerization initiator dissolved therein through the use of at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc.; and a diazo compound or a dichromate.
   In this case, a pigment may be dispersed in the compound having an ethylenically unsaturated group and containing a photopolymerization initiator dissolved therein. The dispersion of the pigment in the compound leads to an advantage that the color depth is increased.
4. A photosensitive emulsion comprising: the above-described aqueous resin emulsion containing an internally added pigment wherein at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc., is polymerized as a protective colloid agent; and, addition-condensed with the water-soluble polymer serving as a protective colloid of the aqueous resin emulsion, at least one photosensitive compound selected from the group consisting of styrylpyridinium salt compounds, styrylquinolinium salt compounds and N-methylolacrylamide.
   It is also possible to use the photosensitive resin composition in the form of a mixture with a diazo compound or a dichromate.
5. A mixture comprising: a photosensitive emulsion comprised of the above-described aqueous resin emulsion containing an internally added pigment wherein at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc. is polymerized as a protective colloid agent, and, addition-condensed with the water-soluble polymer serving as a protective colloid of the aqueous resin emulsion, at least one photosensitive compound selected from the group consisting of styrylpyridinium salt compounds, styrylquinolinium salt compounds and N-methylolacrylamide; and a photosensitive polymer comprising at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc. and, addition-condensed with the water-soluble polymer, at least one photosensitive compound selected from the group consisting of styrylpyridinium salt compounds, styrylquinolinium salt compounds and N-methylolacrylamide.
   It is also possible to use the photosensitive resin composition in the form of a mixture with a diazo compound or a dichromate.
6. A mixture comprising: a photosensitive emulsion comprised of the above-described aqueous resin emulsion containing an internally added pigment wherein at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc. is polymerized as a protective colloid agent, and, addition-condensed with the water-soluble polymer serving as a protective colloid of the aqueous resin emulsion, at least one photosensitive compound selected from the group consisting of styrylpyridinium salt compounds, styrylquinolinium salt compounds and N-methylolacrylamide; and an emulsified dispersion produced by emulsifying at least one compound having an ethylenically unsaturated group selected from the group consisting of acrylic esters and methacrylic esters containing a photopolymerization initiator dissolved therein through the use of a photosensitive polymer comprising at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc. and, addition-condensed with the water-soluble polymer, at least one photosensitive compound selected from the group consisting of styrylpyridinium salt compounds, styrylquinolinium salt compounds and N-methylolacrylamide.
   In this case, a pigment may be dispersed in the compound having an ethylenically unsaturated group and containing a photopolymerization initiator dissolved therein. The dispersion of the pigment in the compound leads to an advantage that the color depth is increased.
   It is also possible to use the photosensitive resin composition in the form of a mixture with a diazo compound or a dichromate.
7. A mixture comprising: the above-described aqueous resin emulsion containing an internally added pigment wherein at least one surfactant selected from the group consisting of anionic surfactants, cationic surfactants, ampholytic surfactants and nonionic surfactants is polymerized as an emulsion stabilizer; and at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc.; and a diazo compound or a dichromate.
8. A mixture comprising: the above-described aqueous resin emulsion containing an internally added pigment wherein at least one surfactant selected from the group consisting of anionic surfactants, cationic surfactants, ampholytic surfactants and nonionic surfactants is polymerized as an emulsion stabilizer; an emulsified dispersion produced by emulsifying at least one compound having an ethylenically unsaturated group selected from the group consisting of acrylic esters and methacrylic esters containing a photopolymerization initiator dissolved therein through the use of at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc.; and a diazo compound or a dichromate.
   In this case, a pigment may be dispersed in the compound having an ethylenically unsaturated group and containing a photopolymerization initiator dissolved therein. The dispersion of the pigment in the compound leads to an advantage that the color depth is increased.
9. A mixture comprising: the above-described aqueous resin emulsion containing an internally added pigment wherein at least one surfactant selected from the group consisting of anionic surfactants, cationic surfactants, ampholytic surfactants and nonionic surfactants is polymerized as an emulsion stabilizer; and a photosensitive polymer comprising at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc., and, addition-condensed with the water-soluble polymer, at least one photosensitive compound selected from the group consisting of styrylpyridinium salt compounds, styrylquinolinium salt compounds and N-methylolacrylamide.
   It is also possible to use the photosensitive resin composition in the form of a mixture with a diazo compound or a dichromate.
10. A mixture comprising: the above-described aqueous resin emulsion containing an internally added pigment wherein at least one surfactant selected from the group consisting of anionic surfactants, cationic surfactants, ampholytic surfactants and nonionic surfactants is polymerized as an emulsion stabilizer; and an emulsified dispersion produced by emulsifying at least one compound having an ethylenically unsaturated group selected from the group consisting of acrylic esters and methacrylic esters containing a photopolymerization initiator dissolved therein through the use of a photosensitive polymer comprising at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid, water-soluble nylon, etc., and, addition-condensed with the water-soluble polymer, at least one photosensitive compound selected from the group consisting of styrylpyridinium salt compounds, styrylquinolinium salt compounds and N-methylolacrylamide.

In this case, a pigment may be dispersed in the compound having an ethylenically unsaturated group and containing a photopolymerization initiator dissolved therein. The dispersion of the pigment in the compound leads to an advantage that the color depth is increased.

It is also possible to use the photosensitive resin composition in the form of a mixture with a diazo compound or a dichromate.

However, the photosensitive resin compositions 1, 2, 3, 7 and 8 as indicated above comprising a diazo compound or dichromate as the photosensitive compound and the above-described aqueous resin emulsion containing an internally added pigment have a poor redissolution in water in the unexposed portion, so that it is difficult to completely remove the unexposed portion and the color is liable to remain on the substrate. In this case, the dissolution in water may be fairly improved where the water pressure upon the development with water shower is raised the proportion of the protective colloid agent in the photosensitive resin composition or the water-soluble polymer added later is increased.

On the other hand, the photosensitive resin compositions 4, 5, 6, 9 and 10 as indicated above in which a water-soluble polymer such as a partially saponified polyvinyl acetate which is a protective colloid agent of the above-described aqueous resin emulsion containing an internally added pigment is addition-condensed with a photosensitive compound selected from the styrylpyridinium salt compounds and styrylquinolinium salt compounds have the quaternary salt of the photosensitive compound integrally incorporated in the protective colloid agent. Thus, the compositions have an advantage, possibly due to the improvement in the redissolution in water, in that the unexposed portion can be completely removed so that no color remains on the substrate, even where the water shower pressure is not raised or a water-soluble polymer such as a partially saponified polyvinyl chloride having a styrylpyridinium salt compound or styrylquinolinium salt compound residue is not added.

In the above-described constructions 4, 5, 6, 9 and 10, partially saponified polyvinyl acetate derivatives having a styryl compound residue as disclosed in Japanese Unexamined Patent Publication (Kokai) Nos. 1-172831 and 2-160807 and partially saponified polyvinyl acetate derivatives having a sulfonate group or a carboxylate group as disclosed in Japanese Unexamined Patent Publication (Kokai) No. 59-213705 may be used as the protective colloid agent and the water-soluble polymer to be mixed.

Further, in addition to the above-described constructions 1 to 10, the following composition as well can be easily hit upon from the present invention. Specifically, such a composition is a photosensitive resin composition free from the above-described aqueous resin emulsion containing an internally added pigment and comprises: an emulsified dispersion produced by emulsifying a pigment-containing oligomer comprised of at least one compound selected from the group consisting of acrylic esters and methacrylic esters and containing a photopolymerization initiator dissolved therein and, dispersed therein, a pigment through the use of a protective colloid agent (which may be used in combination with a surfactant), for example, a water-soluble polymer such as partially saponified polyvinyl acetate; and a photocrosslinking agent.

Additives usually contained in this type of photosensitive resin composition, for example, antifoaming agents, cissing preventives, preservatives, thermal polymerization inhibitors and leveling agents, may be properly added to the above-described photosensitive resin compositions 1 to 10.

Further, it is also possible to use the above-described photosensitive resin compositions 1 to 10 after an organic pigment or an inorganic pigment dispersed in a dispersant, such as a surfactant, is added thereto to adjust the color depth or the like.

The pigment-containing photosensitive resin composition thus produced is coated on a substrate, for example, by rotary coating, roll coating, dip coating, spray coating, printing or the like, so that the coating thickness on a dry basis is in the range from 0.1 to 10 µm, preferably in the range of from about 0.5 to 3 µm. The wet coating is dried by means of a hot-air drier, a hot plate or the like. After drying, a mask having a predetermined shape, such as a dot pattern or a striped pattern, is brought to a close contact with the coating which is then subjected to a pattern exposure through the mask by means of a light source such as a xenon lamp, a metal halide lamp, an ultrahigh pressure mercury lamp or the like. Then, the exposed coating is subjected to a spray development or a dip development by means of a developer, such as water or water/organic solvent, to selectively remove non-exposed portions. The above-described procedure is repeated a plurality of times to provide a transparent colored image having a plurality of colors without the formation of a resin film for protection against dyeing.

A transparent glass, a transparent resin film, a metallic plate, a ceramic plate, a solid image pickup device as a photoelectric transducing device may be used as the substrate. The transparent colored image may be formed directly on a substrate. Alternatively, the transparent colored image may be formed indirectly on a substrate provided with a black matrix or a substrate provided with an intermediate layer comprising an undercoating agent or the like. Further, any cover coat layer may be provided on the transparent colored image.

The transparent colored image thus formed exhibits substantially no change in the spectral transmission characteristics even when it is heated at 200°C for several tens of minutes, that is, has an excellent heat resistance. It is noted that images dyed with a general organic dye exhibit remarkable fading when they are heated at 200°C for several tens of minutes. Further, under such a condition that the system is sufficiently purged with nitrogen, substantially no change in the spectral transmission characteristics occurs even when the transparent colored image is heated at 250°C for several tens of minutes.

In respect of the light fastness as well, the transparent colored image exhibits a 3- to 4-fold alleviation in the fading phenomenon over the image dyed with an organic dye.

### EXAMPLES

The present invention will now be described in more detail with reference to the following Examples, though it is not limited to these Examples only.

### Example 1

### Step 1:

20 Parts by weight of Chromophtal Blue 4GNP (a blue pigment manufactured by Ciba-Geigy Aktiengesellshaft) as an organic pigment was mixed with 50 parts by weight of butyl acrylate, 20 parts by weight of 2-ethylhexyl acrylate and 10 parts by weight of 1,6-hexanediol diacrylate, and dispersion was sufficiently conducted so that the particle diameter of the pigment became 0.2 µm or less, thereby providing an oligomer containing a blue pigment.

Then, 0.5 part by weight of 2,2'-azobisisobutyronitrile was added as a thermal polymerization initiator to 100 parts by weight of the oligomer containing a blue pigment, and suspension polymerization was conducted through the use of 110 parts by weight of a 10 wt.% aqueous solution of partially saponified polyvinyl acetate having an average degree of polymerization of 1700 and a degree of saponification of 88 % by mole as a protective colloid agent according to a conventional process.

The particle diameter of the synthesized aqueous resin emulsion containing an internally added blue pigment was 0.5 µm or less. The blue pigment particle was immobilized within the emulsion particle, and no change in the state of dispersion of the emulsion particle was observed over a long period of time of 3 months or more.

100 Parts of the above-described aqueous resin emulsion containing an internally added blue pigment and having a solid content adjusted to 20 % by weight was addition-condensed with 0.2 part by weight of N-methyl-4-(p-formylstyryl)pyridinium metasulfate according to a conventional method to provide a blue-sensitive resin composition.

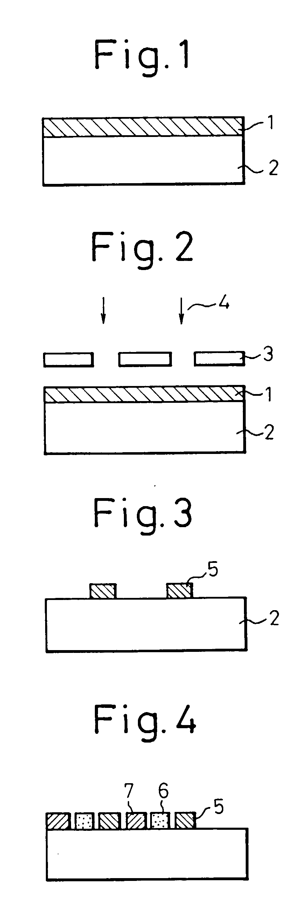

Then, a blue-transparent, colored image was formed as shown in Figs. 1 to 3. At the outset, the above-described blue-sensitive resin composition 1 was coated on a transparent glass substrate 2 so that the coating thickness on a dry basis was 1 µm (see Fig. 1), the coating was subjected to a pattern exposure to an ultraviolet radiation 4 through a mask 3 having a predetermined shape, and the exposed coating was developed and dried (see Fig. 2) to form a blue-transparent, colored image 5 (see Fig. 3). The adhesion between the formed blue-transparent, colored image and the glass substrate was good, and the blue-transparent, colored image was a homogeneous image free from local missing of color.

The transmission of the resultant blue-transparent, colored image was 75 % at 460 nm and 5 % at 620 nm. Substantially no change in the spectral transmission characteristics was observed even when the blue-transparent, colored image was heated at 200°C for 60 min. Further, a 1000-hr light fastness test was conducted by means of a xenon fadeometer. As a result, the change in the spectral transmission characteristics was very small, and the change in the peak transmission and the shift of the peak wavelength were 5 % or less and 5 nm or less, respectively.

### Step 2:

An aqueous resin emulsion containing an internally added green pigment was prepared in the same manner as that of Step 1, except that 20 parts by weight of Chromophtal Green GFN (a green pigment manufactured by Ciba-Geigy Aktiengesellshaft) was used as an organic pigment. As with the emulsion particle prepared in Step 1, the resultant emulsion particle was stable over a long period of time.

A green-transparent, colored image was formed in the same manner as that of Step 1, except that use was made of the green-sensitive resin composition. The green-transparent, colored image was excellent in both the adhesion and homogeneity and exhibited a transmission of 75 % at 540 nm and 3 % at 640 nm. The spectral transmission characteristics remained good without significant change even when it was heated at 200°C for 60 min, and exhibited good results in the 1000-hr light fastness test wherein use was made of a xenon fadeometer.

### Step 3:

An aqueous resin emulsion containing an internally added red pigment was prepared in the same manner as that of Step 1, except that Chromophtal Red A2B (a red pigment manufactured by Ciba-Geigy Aktiengesellshaft) was used as an organic pigment. As with the emulsion particle prepared in Step 1, the resultant emulsion particle was stable over a long period of time.

A red-transparent, colored image was formed in the same manner as that of Step 1, except that use was made of the red-sensitive resin composition. The red transparent, colored image was excellent in both the adhesion and homogeneity and exhibited a transmission of 85 % at 630 nm and 5 % at 540 nm. The spectral transmission characteristics remained good without significant change even when it was heated at 200°C for 60 min, and exhibited good results in the 1000-hr light fastness test wherein use was made of a xenon fadeometer.

### Step 4:

Patterning was repeated by using blue-sensitive, green-sensitive and red-sensitive resin compositions prepared in the above Steps 1, 2 and 3 to form a color filter comprising a transparent glass substrate and, provided thereon, transparent, colored images 5, 6 and 7 in a mosaic pattern of three colors, that is, blue, green and red (see Fig. 4). A transparent conductive film was formed on the resultant colored image, subjected to an orientation treatment and combined with a thin film transistor as a counter electrode. Then, a liquid crystal was injected, and a cell was assembled. The cell was applied to a full color liquid crystal display device. As a result, good characteristics were obtained.

### Example 2

### Step 1:

An aqueous resin emulsion containing an internally added blue pigment was synthesized in the same manner as that of Step 1 of Example 1. 0.2 Part by weight of ammonium dichromate was added to 100 parts by weight of the aqueous resin emulsion containing an internally added blue pigment and having a solid content adjusted to 20 % by weight to provide a blue-sensitive resin composition.

A blue-transparent, colored image was formed in the same manner as that of Step 1 of Example 1, except that use was made of the blue-sensitive resin composition. As with the transparent, colored image formed in Step 1 of Example 1, the blue-transparent, colored image had excellent various characteristics.

### Step 2:

An aqueous resin emulsion containing an internally added green pigment was synthesized in the same manner as that of Step 2 of Example 1. 0.2 Part by weight of ammonium dichromate was added to 100 parts by weight of the aqueous resin emulsion containing an internally added green pigment and having a solid content adjusted to 20 % by weight to provide a green-sensitive resin composition.

A green-transparent, colored image was formed in the same manner as that of Step 2 of Example 1, except that use was made of the green-sensitive resin composition. As with the transparent, colored image formed in Step 2 of Example 1, the resultant green-transparent, colored image had excellent various characteristics.

### Step 3:

An aqueous resin emulsion containing an internally added red pigment was synthesized in the same manner as that of Step 3 of Example 1. 0.2 Part by weight of ammonium dichromate was added to 100 parts by weight of the aqueous resin emulsion containing an internally added red pigment and having a solid content adjusted to 20 % by weight to provide a red-sensitive resin composition.

A red-transparent, colored image was formed in the same manner as that of Step 3 of Example 1, except that use was made of the above-described red-sensitive resin composition. As with the transparent, colored image formed in Step 3 of Example 1, the resultant red-transparent, colored image had excellent various characteristics.

### Step 4:

A color filter was formed in the same manner as that of Step 4 of Example 1, except that use was made of blue-sensitive, green-sensitive and red-sensitive resin compositions prepared in the above Steps 1, 2 and 3. The color filter was applied to a full color liquid crystal display device in the same manner as that of Step 4 of Example 1. As a result, good characteristics were obtained.

### Example 3

### Step 1:

An aqueous resin emulsion containing an internally added blue pigment was synthesized in the same manner as that of Step 1 of Example 1. 0.2 Part by weight of a diazo compound comprising a condensate of p-diazophenylamine with formaldehyde was added to 100 parts by weight of the aqueous resin emulsion containing an internally added blue pigment and having a solid content adjusted to 20 % by weight to provide a blue-sensitive resin composition.

A blue-transparent, colored image was formed in the same manner as that of Step 1 of Example 1, except that use was made of the blue-sensitive resin composition. As with the transparent, colored image formed in Step 1 of Example 1, the blue-transparent, colored image had excellent various characteristics.

### Step 2:

An aqueous resin emulsion containing an internally added green pigment was synthesized in the same manner as that of Step 2 of Example 1. 0.2 Part by weight of the same diazo compound as that used in Step 1 was added to 100 parts by weight of the aqueous resin emulsion containing an internally added green pigment and having a solid content adjusted to 20 % by weight to provide a green-sensitive resin composition.

A green-transparent, colored image was formed in the same manner as that of Step 2 of Example 1, except that use was made of the above-described green-sensitive resin composition. As with the transparent, colored image formed in Step 2 of Example 1, the green-transparent, colored image had excellent various characteristics.

### Step 3:

An aqueous resin emulsion containing an internally added red pigment was synthesized in the same manner as that of Step 3 of Example 1. 0.2 Part by weight of the same diazo compound as that used in Step 1 was added to 100 parts by weight of the aqueous resin emulsion containing an internally added red pigment and having a solid content adjusted to 20 % by weight to provide a red-sensitive resin composition.

A red-transparent, colored image was formed in the same manner as that of Step 3 of Example 1, except that use was made of the red-sensitive resin composition. As with the transparent, colored image formed in Step 3 of Example 1, the red-transparent, colored image had excellent various characteristics.

### Step 4:

A color filter was formed in the same manner as that of Step 4 of Example 1, except that use was made of blue-sensitive, green-sensitive and red-sensitive resin compositions prepared in the above Steps 1, 2 and 3. The color filter was applied to a full color liquid crystal display device in the same manner as that of Step 4 of Example 1. As a result, good characteristics were obtained.

According to the present invention, the use of a photosensitive resin composition comprising an aqueous resin emulsion containing an internally added pigment and excellent in the dispersion stability by virtue of the immobilization of the pigment within the emulsion particle enables a color filter provided with a fine pattern and excellent in various characteristics, such as light fastness and heat resistance, to be produced through a sample production process.

Therefore, the color filter can be applied to a wide variety of devices wherein a color filter having a good performance is necessary, which enables a color device having excellent various characteristics to be produced.

## Claims

1. A color filter comprising a substrate and, provided thereon, a pattern having a plurality of colors produced by conducting photocrosslinking of a photosensitive resin composition comprising: an aqueous resin emulsion containing an internally added pigment, said aqueous resin emulsion being produced by subjecting a compound having an ethylenically unsaturated group to emulsion polymerization or suspension polymerization in water in the presence of a pigment; and a photocrosslinking agent.

2. A color filter as set forth in claim 1, wherein the pigment is selected from the group consisting of organic pigments of azo, phthalocyanine, benzimidazolone, quinacridone, isoindolinone, pyranthrone, dibromoansanthrone, indanthrone, anthrapyrimidine, flavanthrone, perylene, perinone, quinophthalone, phthalone, thioindigo, indigo, dioxazine, anthraquinone, xanthene, methine and azomethine pigments and other polycondensed ring pigments including metal complex polycondensed ring pigments and inorganic pigments of milori blue, iron oxide, cobalt violet, manganese violet, ultramarine blue, iron blue, cobalt blue, cerulean blue, viridian, emerald green and cobalt green.

3. A color filter as set forth in claim 1, wherein the pigment has a particle diameter of 0.7 µm or less.

4. A color filter as set forth in claim 1, wherein the compound having an ethylenically unsaturated group is selected from the group consisting of alkyl acrylates, alkyl methacrylates, epoxy acrylates, epoxy methacrylates, urethane acrylates, urethane methacrylates, polyether acrylates, polyether methacrylates, polyester acrylates, polyester methacrylates, acrylic acid, methacrylic acid, glycidyl acrylate, glycidyl methacrylate, allyl acrylate, allyl methacrylate, itaconic acid, acrylamide, methacrylamide, dimethylaminoethyl acrylate, diethylaminoethyl methacrylate, hydroxyethyl acrylate, hydroxyethyl methacrylate, hydroxypropyl acrylate, hydroxypropyl methacrylate, N-methylolacrylamide, N-methylolmethacrylamide, acrylonitrile, styrene, α-methylstyrene, vinyl acetate, vinyltoluene, vinylpyridine, 2-hydroxy-3-phenoxypropyl acrylate, p-nonylphenoxyethyl acrylate, 1,6-hexanediol diacrylate, 1,6-hexanediol dimethacrylate, neopentyl glycol diacrylate, neopentyl glycol dimethacrylate, 2-hydroxy-1-acryloxy-3-methacryloxypropane, 3-butylene glycol dimethacrylate, 2,2-bis [4 (acryloxypolyethoxyphenyl]propane, 2,2-bis [4(methacryloxypolyethoxy)phenyl]propane, trimethylolpropane triacrylate, tetramethylolmethane triacrylate, tetramethylolmethane tetraacrylate, dipentaerythritol hexaacrylate, butadiene, isoprene, chloroprene, vinyl chloride, vinyl bromide, vinylidene chloride and vinylidene fluoride.

5. A color filter as set forth in claim 1, wherein the ratio of the weight (A) of the pigment to the weight (B) of the-compound having an ethylenically unsaturated group is in the range of from 1:99 to 80:20.

6. A color filter as set forth in claim 1, wherein the photosensitive resin composition is a mixture comprising: said aqueous resin emulsion containing an internally added pigment wherein at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid and water-soluble nylon is polymerized as a protective colloid agent; and a diazo compound or a dichromate.

7. A color filter as set forth in claim 6 wherein said mixture further comprises at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid and water-soluble nylon.

8. A color filter as set forth in claim 6 wherein said mixture further comprises an emulsified dispersion produced by emulsifying at least one compound having an ethylenically unsaturated group selected from the group consisting of acrylic esters and methacrylic esters containing a photopolymerization initiator dissolved therein through the use of at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid and water-soluble nylon.

9. A color filter as set forth in claim 6 wherein the photosensitive resin composition is a photosensitive emulsion comprising said aqueous resin emulsion and, addition-condensed with the water-soluble polymer serving as a protective colloid of the aqueous resin emulsion, at least one photosensitive compound selected from the group consisting of styrylpyridinium salt compounds, styrylquinolinium salt compounds and N-methylolacrylamide.

10. A color filter as set forth in claim 9 wherein the photosensitive resin composition is a mixture comprising said photosensitive emulsion, a photosensitive polymer comprising at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid and water-soluble nylon, and, addition-condensed with the water-soluble polymer, at least one photosensitive compound selected from the group consisting of styrylpyridinium salt compounds, styrylquinolinium salt compounds and N-methylolacrylamide.

11. A color filter as set forth in claim 1, wherein the photosensitive resin composition is a mixture comprising said photosensitive emulsion, an emulsified dispersion produced by emulsifying at least one compound having an ethylenically unsaturated group selected from the group consisting of acrylic esters and methacrylic esters containing a photopolymerization initiator dissolved therein through the use of a photosensitive polymer comprising at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid and water-soluble nylon, and, addition-condensed with the water-soluble polymer, at least one photosensitive compound selected from the group consisting of styrylpyridinium salt compounds, styrylquinolinium salt compounds and N-methylolacrylamide.

12. A color filter as set forth in claim 1, wherein the photosensitive resin composition is a mixture comprising: said aqueous resin emulsion containing an internally added pigment wherein at least one surfactant selected from the group consisting of anionic surfactants, cationic surfactants, ampholytic surfactants and nonionic surfactants is polymerized as an emulsion stabilizer; and at least one water-soluble polymer selected from the group consisting of partially saponified polyvinyl acetate, partially saponified polyvinyl acetate derivatives, gelatin, casein, collagen, starch, starch derivatives, gum arabic, cellulose derivatives, polyacrylamide, polyacrylic acid and watersoluble nylon; and a diazo compound or a dichromate.

13. A color filter as set forth in claim 12 wherein the photosensitive resin composition is a mixture comprising said aqueous resin emulsion and an emulsified dispersion produced by emulsifying at least one compound having an ethylenically unsaturated group selected from the group consisting of acrylic esters and methacrylic esters containing a photopolymerization initiator dissolved therein through the use of said at least one water-soluble polymer.

14. A color filter as set forth in claim 12 wherein the photosensitive resin composition is a mixture comprising said aqueous resin emulsion, a photosensitive polymer comprising said at least one water-soluble polymer and, addition-condensed with said water-polymer, at least one photosensitive compound selected from the group consisting of styrylpyridinium salt compounds, styrylquinolinium salt compounds and N-methylolacrylamide.

15. A color filter as set forth in claim 13 wherein the photosensitive resin composition is a mixture comprising said aqueous resin emulsion and, addition-condensed with said water-soluble polymer, at least one photosensitive compound selected from the group consisting of styrylpyridinium salt compounds, styrylquinolinium salt compounds and N-methylolacrylamide.

## Patentansprüche

1. Ein Farbfilter, der aus einem Substrat und darauf aus einem Muster besteht, das eine Vielzahl von Farben besitzt, die durch gesteuerte Photovernetzung einer photosensitiven Harzmischung erzeugt werden, die umfaßt: eine wässerige Harzemulsion, die ein darin befindliches Pigment enthält, besagte wässerige Harzemulsion, die durch Unterwerfen einer Komponente, die eine ethylenisch-ungesättige Gruppe besitzt, einer Emulsionspoylmerisation oder Suspensionspolymerisation in Wasser in Gegenwart eines Pigments hergestellt wurde; und eines Photovernetzers.

2. Ein Farbfilter nach Anspruch 1., dadurch gekennzeichnet, daß das Pigment aus einer Gruppe ausgewählt wurde, die aus organischen Pigmenten von Azo-, Phthalocyanin-, Benzimidazol-, Chinacridon-, Isoindolinon-, Pyranthron-, Dibromansanthron-, Indanthron-, Anthrapyrimidin-, Indanthren-, Perylen-, Perinon-, Chinophthalon-, Phthalon-, Thioindigo-, Indigo-, Dioxazin-, Anthrachinon-, Xanthen-, Methin- und Azomethin-Pigmente und andere polykondensierte Ringpigmente einschließlich metallkomplex-polykondensierte Ringpigmente und anorganischen Pigmenten von Miloriblau, Eisenoxid, Kobaltviolett, Manganviolett, Ultramarinblau, Eisenblau, Kobaltblau, Coelestinblau, Guignetgrün, Smaragdgrün und Kobaltgrün besteht.

3. Ein Farbfilter nach Anspruch 1., dadurch gekennzeichnet, daß das Pigment einen Teilchendurchmesser von 0,7 µm oder weniger hat.

4. Ein Farbfilter nach Anspruch 1., dadurch gekennzeichnet, daß die Komponente, die eine ethylenisch-ungesättigte Gruppe hat, aus der Gruppe gewählt wurde, die aus Alkylacrylaten, Alkylmethacrylaten, Epoxyacrylaten, Epoxmethacrylaten, Urethanacrylaten, Urethanmethacrylaten, Polyetheracrylaten, Polyethermethacrylaten, Polyesteracrylaten, Polyestermethacrylaten, Acrylsäure, Methacrylsäure, Glycidylacrylat, Glycidylmethacrylat, Allylacrylat, Allylmethacrylat, Methylenbernsteinsäure, Acrylamid, Methacrylamid, Dimethylaminoethylacrylat, Diethylaminoethylmethacrylat, Hydroxyethylacrylat, Hydroxyethylmethacrylat, Hydroxypropylacrylat, Hydroxypropylmethacrylat, N-Methylolacrylamid, N-Methylolmethacrylamid, Acrylnitril, Styren, α-Methylstyren, Vinylacetat, Vinyltoluen, Vinylpyridin, 2-Hydroxy-3-phenoxypropylacrylat, p-Nonylphenoxyethylacrylat, 1,6-Hexandioldiacrylat, 1,6-Hexandioldimethacrylat, Neopentylglycoldiacrylat, Neopentylglycoldimethacrylat, 2-Hydroxy-1-acryloxy-3-methacryloxypropan, 3-Butylenglycoldimethacrylat, 2,2-Bis [4-(acryloxypolyethoxy)phenyl]propan, 2,2-Bis [4-(methacryloxypolyethoxy)phenyl]propan, Trimethylolpropantriacrylat, Tetramethylolmethantriacrylat, Tetramethylolmethantetraacrylat, Dipentaerythritolhexaacrylat, Butadien, Isopren, Chloropren, Vinylchlorid, Vinylbromid, Vinylidenchlorid und Vinylidenfluorid besteht.

5. Ein Farbfilter nach Anspruch 1., dadurch gekennzeichnet, daß das Verhältnis von Gewicht (A) des Pigments zu Gewicht (B) der Komponente, die eine ethylenisch-ungesättigte Gruppe hat, im Bereich von 1 : 99 bis 80 : 20 ist.

6. Ein Farbfilter nach Anspruch 1., dadurch gekennzeichnet, daß die photosensitive Harzmischung ein Gemisch ist, das aus besagter wässeriger Harzemulsion, die ein darin befindliches Pigment enthält, wobei wenigstens ein wasserlösliches Polymer, das aus der Gruppe, die teilweise verseiftes Polyvinylacetat, teilweise verseifte Polyvinylacetatderivate, Galert, Casein, Collagen, Stärke, Stärkederivate, Gummiarabicum, Cellulosederivate, Polyacrylamid, Polyacrylsäure und wasserlösliches Nylon enthält, ausgewählt wurde, die als Schutzgruppe polymerisiert wurde; und aus einer Diazo-Verbindung oder einem Dichromat besteht.

7. Ein Farbfilter nach Anspruch 6., dadurch gekennzeichnet, daß die besagte Mischung weiterhin aus wenigstens einem wasserlöslichen Polymer, das aus der Gruppe, die teilweise verseiftes Polyvinylacetat, teilweise verseifte Polyvinylacetatderivate, Galert, Casein, Collagen, Stärke, Stärkederivate, Gummiarabicum, Cellulosederivate, Polyacrylamid, Polyacrylsäure und wasserlösliches Nylon enthält, ausgewählt wurde, besteht.

8. Ein Farbfilter nach Anspruch 6., dadurch gekennzeichnet, daß die besagte Mischung weiterhin aus einer emulgierten Disperison, die durch Emulgierung wenigstens einer Komponente hergestellt wurde, die eine ethylenisch-ungesättigte Gruppe hat und aus der Gruppe, die Acrylsäureester und Methacrylsäureester enthält, gewählt wurde, die einen Photopolymerisationsinitiator enthält, der darin durch die Verwendung wenigstens eines wasserlöslichen Polymers gelöst wurde, das aus einer Gruppe, die teilweise verseiftes Polyvinylacetat, teilweise verseifte Polyvinylacetatderivate, Galert, Casein, Collagen, Stärke, Stärkederivate, Gummiarabicum, Cellulosederivate, Polyacrylamid, Polyacrylsäure und wasserlösliches Nylon enthält, ausgewählt wurde, besteht.

9. Ein Farbfilter nach Anspruch 6., dadurch gekennzeichnet, daß die photosensitive Harzmischung eine photosensitive Emulsion ist, die die besagte wässerige Harzemulsion und die Zugabe wenigstens einer photosensitiven Komponente, die aus der Gruppe, die aus Styrylpyridinsalz-Verbindungen, Styrylchinolinsalz-Verbindungen und N-Methylolacrylamid besteht, gewählt wurde, zusammen mit dem wasserlöslichen Polymer, das als Schutzkolloid für die wässerige Harzemulsion dient, umfaßt.

10. Ein Farbfilter nach Anspruch 9., dadurch gekennzeichnet, daß die photosensitive Harzmischung ein Gemisch ist, das besagte photosensitive Emulsion, ein photosensitives Polymer, das aus wenigstens einem wasserlöslichen Polymer besteht, das aus einer Gruppe, die teilweise verseiftes Polyvinylacetat, teilweise verseifte Polyvinylacetatderivate, Galert, Casein, Collagen, Stärke, Stärkederivate, Gummiarabicum, Cellulosederivate, Polyacrylamid, Polyacrylsäure und wasserlösliches Nylon enthält, ausgewählt wurde, und die Zugabe wenigstens einer photosensitiven Komponente, die aus der Gruppe, die aus Styrylpyridinsalz-Verbindungen, Styrylchinolinsalz-Verbindungen und N-Methylolacrylamid besteht, gewählt wurde, zusammen mit dem wasserlöslichen Polymer, umfaßt.

11. Ein Farbfilter nach Anspruch 1., dadurch gekennzeichnet, daß die photosensitive Harzmischung ein Gemisch ist, das besagte photosensitive Emulsion, eine emulgierte Disperison, die durch Emulgierung wenigstens einer Komponente hergestellt wurde, die eine ethylenisch-ungesättigte Gruppe hat und aus der Gruppe, die Acrylsäureester und Methacrylsäureester enthält, gewählt wurde, die einen Photopolymerisationsinitiator enthält, der darin durch die Verwendung eines photosensitiven Polymers gelöst wurde, das aus wenigstens einem wasserlöslichen Polymer besteht, das aus einer Gruppe, die teilweise verseiftes Polyvinylacetat, teilweise verseifte Polyvinylacetatderivate, Galert, Casein, Collagen, Stärke, Stärkederivate, Gummiarabicum, Cellulosederivate, Polyacrylamid, Polyacrylsäure und wasserlösliches Nylon enthält, ausgewählt wurde, und die Zugabe wenigstens einer photosensitiven Komponente, die aus der Gruppe, die aus Styrylpyridinsalz-Verbindungen, Styrylchinolinsalz-Verbindungen und N-Methylolacrylamid besteht, gewählt wurde, zusammen mit dem wasserlöslichen Polymer, umfaßt.

12. Ein Farbfilter nach Anspruch 1., dadurch gekennzeichnet, daß die photosensitive Harzmischung ein Gemisch ist, das aus besagter wässeriger Harzemulsion, die ein darin befindliches Pigment enthält, wobei wenigstens ein Tensid, das aus der Gruppe, die aus anionischen Tensiden, kationischen Tensiden, amphoteren Tensiden und nichtionischen Tensiden besteht, ausgewählt wurde und als Emulsionsstabilisator polymerisiert wurde; und aus wenigstens einem wasserlöslichen Polymer, das aus der Gruppe, die teilweise verseiftes Polyvinylacetat, teilweise verseifte Polyvinylacetatderivate, Galert, Casein, Collagen, Stärke, Stärkederivate, Gummiarabicum, Cellulosederivate, Polyacrylamid, Polyacrylsäure und wasserlösliches Nylon enthält, ausgewählt wurde; und aus einer Diazo-Verbindung oder einem Dichromat besteht.

13. Ein Farbfilter nach Anspruch 12., dadurch gekennzeichnet, daß die photosensitive Harzmischung ein Gemisch ist, das aus besagter wässeriger Harzemulsion und einer emulgierten Disperison, die durch Emulgierung wenigstens einer Komponente hergestellt wurde, die eine ethylenisch-ungesättigte Gruppe hat und aus der Gruppe, die Acrylsäureester und Methacrylsäureester enthält, gewählt wurde, die einen Photopolymerisationsinitiator enthält, der darin durch die Verwendung wenigstens eines besagten, wasserlöslichen Polymers gelöst wurde, besteht.

14. Ein Farbfilter nach Anspruch 12., dadurch gekennzeichnet, daß die photosensitive Harzmischung ein Gemisch ist, das besagte wässerige Harzemulsion, ein photosensitives Polymer, das wenigstens ein besagtes, wasserlösliches Polymer enthält, und die Zugabe wenigstens einer photosensitiven Komponente, die aus der Gruppe, die aus Styrylpyridinsalz-Verbindungen, Styrylchinolinsalz-Verbindungen und N-Methylolacrylamid besteht, zusammen mit dem besagten wasserlöslichen Polymer, umfaßt.

15. Ein Farbfilter nach Anspruch 13., dadurch gekennzeichnet, daß die photosensitive Harzmischung ein Gemisch ist, das besagte wässerige Harzemulsion und die Zugabe wenigstens einer photosensitiven Komponente, die aus der Gruppe, die aus Styrylpyridinsalz-Verbindungen, Styrylchinolinsalz-Verbindungen und N-Methylolacrylamid besteht, zusammen mit dem besagten wasserlöslichen Polymer, umfaßt.

## Revendications

1. Filtre couleur comprenant un substrat et muni d'un "motif' ayant une pluralité de couleurs produit par photoréticulation d'une composition de résine photosensible comprenant : une émulsion de résine aqueuse contenant un pigment interne ajouté, ladite émulsion de résine aqueuse étant produite en soumettant un composé ayant un groupe insaturé éthylénique à une polymérisation par émulsion ou à une polymérisation par suspension dans l'eau en présence d'un pigment ; et un agent de photoréticulation.

2. Filtre couleur selon la revendication 1 dans lequel le pigment est choisi parmi les pigments organiques de azo, phtalocyanine, benzimidazolone, quinacridone, isoindolinone, pyranthrone, dibromoansanthrone, indanthrone, anthrapyrimidine, flavanthrone, pérylène, périnone, quinophtalone, phtalone, thioindigo, indigo, dioxazine, anthraquinone, xanthène, méthine et azométhine et d'autres pigments au noyau polycondensé incluant des pigments aux noyaux polycondensés complexés avec du métal et les pigments inorganiques tels que le bleu de milori, l'oxyde de fer, le violet de cobalt, le violet de manganèse, le bleu ultra-marine, le bleu de fer, le bleu de cobalt, le bleu cerulean, le viridian, le vert émeraude et le vert de cobalt.

3. Filtre couleur selon la revendication 1 dans lequel le pigment a un diamètre de particule de 0,7 µm ou moins.

4. Filtre couleur selon la revendication 1 dans lequel le composé ayant un groupe insaturé éthylénique est choisi parmi les acrylates d'alkyle, les méthacrylates d'alkyle, les époxy acrylates, les époxy méthacrylates, les uréthane acrylates, les uréthane méthacrylates, les polyéther acrylates, les polyéther méthacrylates, les polyester acrylates, les polyester méthacrylates, l'acide acrylique, l'acide méthacrylique, l'acrylate de glycidyle, le méthacrylate de glycidyle, l'acrylate d'allyle, le méthacrylate d'allyle, l'acide itaconique, l'acrylamide, le méthacrylamide, l'acrylate de diméthylaminoéthyle, le méthacrylate de diéthylaminoéthyle, l'acrylate d'hydroxyéthyle, le méthacrylate d'hydroxyéthyle, l'acrylate d'hydroxypropyle, le méthacrylate d'hydroxypropyle, le N-méthylolacrylamide, le N-méthylométhacrylamide, l'acrylonitrile, le styrène, le α-méthylstyrène, l'acétate de vinyle, le vinyltoluène, la vinylpyridine, l'acrylate de 2-hydroxy-3-phénoxypropyle, l'acrylate de p-nonylphénoxyéthyle, le diacrylate de 1,6-hexanediol, le diméthacrylate de 1,6-hexanediol, le diacrylate de neopentylglycol, le diméthacrylate de neopentylglycol, le 2-hydroxy-1-acryloxy-3-méthacryloxypropane, le diméthacrylate de 3-butylèneglycol, le 2,2-bis[4(acryloxypolyéthoxy)phényl]propane, le 2-2-bis[4(méthacryloxypolyéthoxy)phényl]propane, le triméthylolpropane triacrylate, le tétraméthylolméthane triacrylate, le tétraméthylolméthane tétraacrylate, le dipentaérythritol hexaacrylate, le butadiène, l'isoprène, le chloroprène, le chlorure de vinyle, le bromure de vinyle, le chlorure de vinylidène et le fluorure de vinylidène.

5. Filtre couleur selon la revendication 1, dans lequel le rapport du poids (A) du pigment au poids (B) du composé ayant un groupe insaturé éthylénique est compris entre 1:99 à 80:20.

6. Filtre couleur selon la revendication 1, dans lequel la composition de résine photosensible est un mélange comprenant : ladite émulsion de résine aqueuse contenant un pigment interne ajouté dans lequel au moins un polymère soluble dans l'eau choisi parmi l'acétate de polyvinyle partiellement saponifié, les dérivés d'acétate de polyvinyle partiellement saponifié, la gélatine, la caséine, le collagène, l'amidon, les dérivés d'amidon, la gomme arabique, les dérivés de cellulose, le polyacrylamide, l'acide polyacrylique et le nylon soluble dans l'eau, est polymérisé comme agent colloïdal protecteur; et un composé diazo ou un dichromate.

7. Filtre couleur selon la revendication 6 dans lequel ledit mélange comprend en outre au moins un polymère soluble dans l'eau choisi parmi l'acétate de polyvinyle partiellement saponifié, les dérivés d'acétate de polyvinyle partiellement saponifié, la gélatine, la caséine, le collagène, l'amidon, les dérivés d'amidon, la gomme arabique, les dérivés de cellulose, le polyacrylamide, l'acide polyacrylique et le nylon soluble dans l'eau.

8. Filtre couleur selon la revendication 6 dans lequel ledit mélange comprend en outre une dispersion émulsifiée produit par émulsification d'au moins un composé ayant un groupe insaturé éthylénique choisi parmi les esters acryliques ou les esters méthacryliques contenant un initiateur de photopolymérisation dissous dans celle-ci par l'utilisation d'au moins un polymère soluble dans l'eau choisi parmi l'acétate de polyvinyle partiellement saponifié, les dérivés d'acétate de polyvinyle partiellement saponifié, la gélatine, la caséine, le collagène, l'amidon, les dérivés d'amidon, la gomme arabique, les dérivés de cellulose, le polyacrylamide, l'acide polyacrylique et le nylon soluble dans l'eau.

9. Filtre couleur selon la revendication 6 dans lequel la composition de résine photosensible est une émulsion photosensible comprenant ladite émulsion de résine aqueuse et au moins un composé photosensible choisi parmi les sels de styrylpyridinium, de styrylquinolinium et le N-méthylolacrylamide, ledit composé photosensible étant condensé par addition avec un polymère soluble dans l'eau servant de colloïde protecteur de l'émulsion de résine aqueuse.

10. Filtre couleur selon la revendication 9 dans lequel la composition de résine photosensible est un mélange comprenant ladite émulsion photosensible, un polymère photosensible comprenant au moins un polymère soluble dans l'eau choisi parmi l'acétate de polyvinyle partiellement saponifié, les dérivés d'acétate de polyvinyle partiellement saponifié, la gélatine, la caséine, le collagène, l'amidon, les dérivés d'amidon, la gomme arabique, les dérivés de cellulose, le polyacrylamide, l'acide polyacrylique et le nylon soluble dans l'eau, et, au moins un composé photosensible choisi parmi les sels de styrylpyridinium, de styrylquinolinium et le N-méthylolacrylamide, ledit composé photosensible étant condensé par addition avec le polymère soluble dans l'eau.

11. Filtre couleur selon la revendication 1, dans lequel la composition de résine photosensible est un mélange comprenant ladite émulsion photosensible, une dispersion émulsifiée produite par émulsification d'au moins un composé ayant un groupe insaturé éthylénique choisi parmi les esters acryliques et les esters méthacryliques contenant un initiateur de photopolymérisation dissous dans celle-ci par l'utilisation d'au moins un polymère soluble dans l'eau choisi parmi l'acétate de polyvinyle partiellement saponifié, les dérivés d'acétate de polyvinyle partiellement saponifié, la gélatine, la caséine, le collagène, l'amidon, les dérivés d'amidon, la gomme arabique, les dérivés de cellulose, le polyacrylamide, l'acide polyacrylique et le nylon soluble dans l'eau, et, au moins un composé photosensible choisi parmi les sels de styrylpyridinium, de styrylquinolinium et le N-méthylolacrylamide, ledit composé photosensible étant condensé par addition avec le polymère soluble dans l'eau.

12. Filtre couleur selon la revendication 1, dans lequel la composition de résine photosensible est un mélange comprenant :ladite émulsion de résine aqueuse contenant un pigment interne ajouté dans lequel au moins un tensioactif choisi parmi les tensioactifs anioniques, les tensioactifs cationiques, les tensioactifs ampholytes et les tensioactifs non-ioniques, est polymérisé en tant que stabilisateur d'émulsion ; et au moins un polymère soluble dans l'eau choisi parmi l'acétate de polyvinyle partiellement saponifié, les dérivés d'acétate de polyvinyle partiellement saponifié, la gélatine, la caséine, le collagène, l'amidon, les dérivés d'amidon, la gomme arabique, les dérivés de cellulose, le polyacrylamide, l'acide polyacrylique et le nylon soluble dans l'eau ; et un composé diazo ou un dichromate.

13. Filtre couleur selon la revendication 12 dans lequel la composition de résine photosensible est un mélange comprenant ladite émulsion de résine aqueuse et une dispersion émulsifiée produite par émulsification d'au moins un composé ayant un groupe insaturé éthylénique choisi parmi les esters acryliques et les esters méthacryliques contenant un initiateur de photopolymérisation dissous dans celle-ci par l'utilisation dudit polymère soluble dans l'eau.

14. Filtre couleur selon la revendication 12 dans lequel la composition de résine photosensible est un mélange comprenant ladite émulsion de résine aqueuse, un polymère photosensible comprenant au moins ledit polymère soluble dans l'eau, et au moins un composé photosensible choisi parmi les sels de styrylpyridinium, de styrylquinolinium et le N-méthylolacrylamide, ledit composé photosensible étant condensé par addition avec ledit polymère soluble dans l'eau.

15. Filtre couleur selon la revendication 13 dans lequel la composition de résine photosensible est un mélange comprenant ladite émulsion de résine aqueuse et au moins un composé photosensible choisi parmi les sels de styrylpyridinium, de styrylquinolinium et le N-méthylolacrylamide, ledit composé photosensible étant condensé par addition avec ledit polymère soluble dans l'eau.
